Europäisches Patentamt

European Patent Office

Office européen des brevets

(19)

(11) **EP 1 076 933 B1**

(12) **FASCICULE DE BREVET EUROPEEN**

(45) Date de publication et mention
de la délivrance du brevet:
**27.11.2002   Bulletin 2002/48**

(21) Numéro de dépôt: **99909003.8**

(22) Date de dépôt: **12.03.1999**

(51) Int Cl.⁷: **H03M 13/00**

(86) Numéro de dépôt international:
**PCT/FR99/00549**

(87) Numéro de publication internationale:
**WO 99/048216 (23.09.1999 Gazette 1999/38)**

(54) **DISPOSITIF DE CORRECTION D'ERREURS ET LECTEUR DE DISQUE OPTIQUE COMPORTANT UN TEL DISPOSITIF**

VORRICHTUNG ZUR BERICHTIGUNG VON FEHLERN UND OPTISCHER PLATTENSPIELER, DER EINE SOLCHE VORRICHTUNG EINSCHLIESST

ERROR CORRECTING DEVICE AND OPTICAL DISK READER COMPRISING SAME

(84) Etats contractants désignés:
**DE ES FR GB IT**

(30) Priorité:   **13.03.1998  FR 9803103**

(43) Date de publication de la demande:
**21.02.2001   Bulletin 2001/08**

(73) Titulaire: **THOMSON multimedia**
**92100 Boulogne Billancourt (FR)**

(72) Inventeurs:
  • **DAOUDI, Mohamed**
    **F-92648 Boulogne Cedex (FR)**
  • **VIROULAUD, Christophe**
    **F-92648 Boulogne Cedex (FR)**

  • **PAUL, Philippe**
    **F-92648 Boulogne Cedex (FR)**
  • **ISOLA, Philippe**
    **F-92648 Boulogne Cedex (FR)**

(74) Mandataire: **Kohrs, Martin et al**
**Thomson multimedia**
**46, quai A. Le Gallo**
**92648 Boulogne-Billancourt Cedex (FR)**

(56) Documents cités:
**EP-A- 0 620 654**          **US-A- 4 868 828**
**US-A- 5 170 399**          **US-A- 5 642 367**
**US-A- 5 715 262**

## Description

L'invention concerne un dispositif de correction d'erreurs de type Reed-Solomon et un appareil de lecture optique comportant un tel dispositif. L'invention s'applique notamment dans le cadre de la correction d'erreur dans des appareils de lecture de disques optiques ou magnéto-optiques.

La correction d'erreur de type Reed-Solomon ('RS') est utilisée dans de nombreuses applications. Une des applications les plus répandues est le disque compact ('CD'). Dans l'avenir, les codes RS seront également employés dans le cadre des disques dits 'DVD'.

Bien qu'ayant été développés dans les années 60, les codes RS n'ont été employés dans des appareils pour le grand public que depuis le début des années 80. Ceci est dû en partie au fait que cette correction d'erreur exige une puissance de calcul relativement importante, donc coûteuse. La correction requiert par exemple la multiplication et la division de polynômes, ainsi que la détermination des racines de polynômes. Dans ce cadre, il est intéressant de diminuer le temps de calcul et de réduire la complexité des circuits mis en oeuvre dans cette correction, en vue d'en réduire le coût et d'en augmenter la fiabilité.

Le brevet américain US 5,170,399 décrit un circuit mettant en oeuvre l'algorithme d'Euclide pour la correction d'erreur de type Reed-Solomon. La demande de brevet EP 0 620 654 A2 décrit également un tel circuit.

L'invention a pour objet un codeur décodeur de type Reed-Solomon comportant : un générateur de syndromes pour recevoir un flot de données et pour fournir un polynôme de syndrome et un polynôme d'effacement ; des moyens d'implémentation de l'algorithme d'Euclide, pour recevoir lesdits polynômes de syndrome et d'effacement et pour fournir un polynôme de localisation d'erreur ; des moyens de correction pour corriger, le cas échéant, la ou les erreurs dans le flot de données à l'aide du polynôme de localisation d'erreur ; et dans lequel les moyens d'implémentation comportent des premier et deuxième registres pour mémoriser deux polynômes intermédiaires de localisation et d'évaluation d'erreur, les registres étant divisés en cellules élémentaires montées en série et comportant des moyens de multiplexage et de calcul caractérisé en ce que les cellules sont configurées de sorte que lors d'un cycle d'un signal d'horloge où une opération de calcul est réalisée alors il est possible simultanément d'inverser les données entre les deux registres.

Préférentiellement, les moyens d'implémentation sont agencés pour réaliser le produit du polynôme de localisation d'erreur et d'un polynôme d'effacement pour l'obtention d'un nouveau polynôme de localisation d'erreur.

L'algorithme étendu d'Euclide nécessite la multiplication de polynômes. Selon l'invention, ce fait est mis à profit pour réaliser d'autres multiplications de polynômes nécessaires pour la correction d'erreur, ce qui permet de simplifier les autres parties du dispositif de correction.

Selon un mode de réalisation de l'invention, les moyens de détermination des coefficients sont agencés pour réaliser le produit d'un polynôme de syndromes par le polynôme d'effacement.

L'invention a aussi pour objet un lecteur de disques optiques comportant le dispositif de correction.

D'autres avantages et caractéristiques de l'invention apparaîtront à travers la description d'un exemple de réalisation non limitatif décrit à l'aide des figures parmi lesquelles :

la figure 1 est un diagramme illustrant le codage RS d'un bloc de données de type CD,
la figure 2 est un diagramme illustrant le codage RS d'un bloc de données de type DVD,
la figure 3 est un diagramme bloc du dispositif conforme au présent exemple de réalisation,
la figure 4 est un diagramme bloc illustrant les échanges de données en mode dit mode 'DVD',
la figure 5 est un diagramme bloc illustrant les échanges de données en mode dit mode 'CD',
la figure 6 est un diagramme illustrant le stockage d'un paquet de données de type DVD dans une mémoire du dispositif conforme à l'invention,
la figure 7 est un diagramme illustrant l'organisation des données à l'intérieur d'une mémoire du dispositif conforme à l'invention,
la figure 8 est un schéma des deux registres de coefficients de polynômes utilisés par le résolveur d'équations des figures 3 à 5,
la figure 9 est un diagramme illustrant la connexion de cellules à registres dans un circuit résolveur d'équations utilisé dans le décodage Reed-Solomon,
la figure 10 est un diagramme bloc d'une cellule de la figure 9,
la figure 11 est un diagramme bloc de l'extrémité de sortie des registres de la figure 9,
la figure 12 est un diagramme bloc de la cellule de la figure 10 dans une première configuration,
la figure 13 est un diagramme bloc de la cellule de la figure 10 dans une seconde configuration,
la figure 14 est un diagramme bloc de la cellule de la figure 10 dans une troisième configuration,
la figure 15 est un diagramme bloc de plusieurs cellules de la figure 10 placées en série selon une première configuration,
la figure 16 est un diagramme bloc de plusieurs cellules de la figure 10 placées en série selon une deuxième configuration,

la figure 17 est un diagramme bloc d'un lecteur de disque optique comportant un dispositif conforme à l'invention.

Le standard CD ('Compact Disc') préconise l'utilisation d'un code correcteur d'erreur Reed-Solomon à entrelacement croisé ("Cross Interleaved Reed-Solomon error-correction code" ou CIRC). La mise en oeuvre de ce code comporte le partage de chaque échantillon digital de 16 bits à coder en deux symboles de 8 bits.

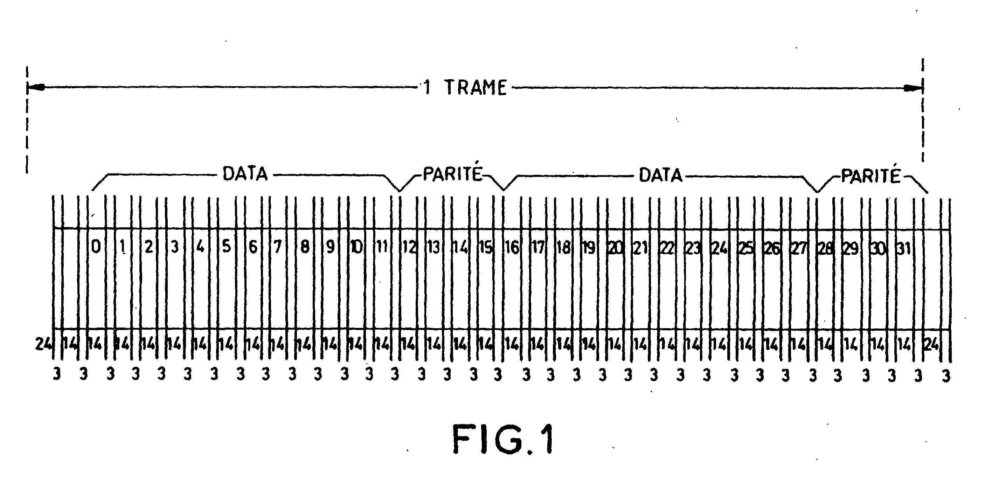

La figure 1 illustre plus particulièrement la structure d'un bloc de données (trame) conformément au standard CD.

Les échantillons à coder sont stockés dans une mémoire vive et présentés à l'encodeur sous la forme de blocs de vingt-quatre symboles (correspondant à six échantillons de 16 bits pour chacun des deux canaux). Selon une première étape, ces symboles sont entrelacés, en retardant de deux échantillons les échantillons pairs et en intervertissant les connexions vers la première partie de l'encodeur, dit encodeur C2. L'encodeur C2 détermine quatre symboles de parité de 8 bits (dits symboles Q) à partir du mot de code de 24 symboles, et insère les quatre symboles de parité parmi les autres symboles. En résultent 28 symboles. L'encodeur C2 est donc un encodeur (28,24).

Les symboles sont transmis au second encodeur, appelé encodeur C1, à travers 28 lignes à retard de longueur inégale, multiples de quatre blocs, de façon à répartir les 28 symboles d'un mot sur 28 blocs différents. Ces 28 blocs seront ensuite entrelacés avec d'autres blocs, à raison d'un bloc parmi les 28 blocs pour trois autres blocs. L'encodeur ajoute quatre symboles de parité de 8 bits supplémentaires (symboles P) à chaque bloc, portant le total à 32 symboles. L'encodeur C1 est donc un encodeur (32,28). Ces symboles sont utilisés, après un traitement supplémentaire consistant à inverser les symboles de parité et à retarder les symboles pairs, pour former un paquet de données.

A ces données s'ajoutent un certain nombre d'informations de contrôle, qui ne seront pas détaillées ici. Pour plus d'informations sur le codage des données, on se reportera entre autres au chapitre 9 de l'ouvrage 'Digital Audio and Compact Disc Technology', troisième édition 1995, Sony Service Centre Europe, ou encore à l'ouvrage 'Reed-Solomon Codes and their applications', Wicker/Bhagarva, IEEE Press 1994, chapitre 4.

La correction des paquets de type CD nécessite donc deux passes à travers un décodeur Reed-Solomon, la première pour le décodage C1 et la seconde pour le décodage C2, avec un désentrelacement entre les deux passes.

Si la capacité de correction de C1 est dépassée (en fonction du nombre d'effacements et d'erreurs à corriger), les 28 symboles (32 moins les quatre symboles de parité P) sont marqués de drapeaux d'effacement ('erasure flags') et ne sont pas corrigés. Lors du désentrelacement, ces 28 symboles seront répartis sur 28 blocs.

Si la capacité de correction de C2 est dépassée, les 24 symboles (28 moins les quatre symboles de parité Q) sont marqués d'un drapeau et ne sont pas corrigés.

La correction d'erreur utilisée dans le cadre du DVD ('Digital Video/Versatile Disc') est différente: un bloc de 192 lignes de 172 symboles (un symbole = 1 octet) est associé verticalement à un code Reed-Solomon dit externe ('PO') composé de 16 lignes de 172 octets, puis horizontalement à un code Reed-Solomon dit interne ('PI') composé de 208 lignes de 10 octets. Le code interne est calculé à partir du bloc de données et à partir du code externe. L'ensemble donne un bloc de 208 lignes de 182 octets. Les 16 lignes du code externe sont ensuite insérées de manière entrelacée parmi les 192 lignes restantes.

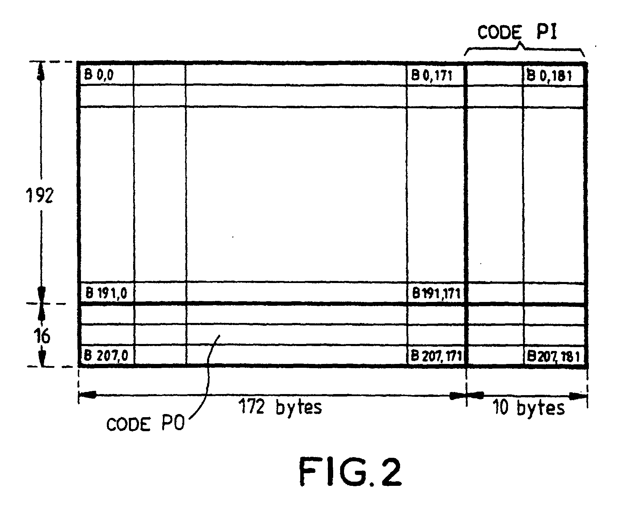

La structure d'un paquet de données conforme au standard DVD est illustrée par la figure 2.

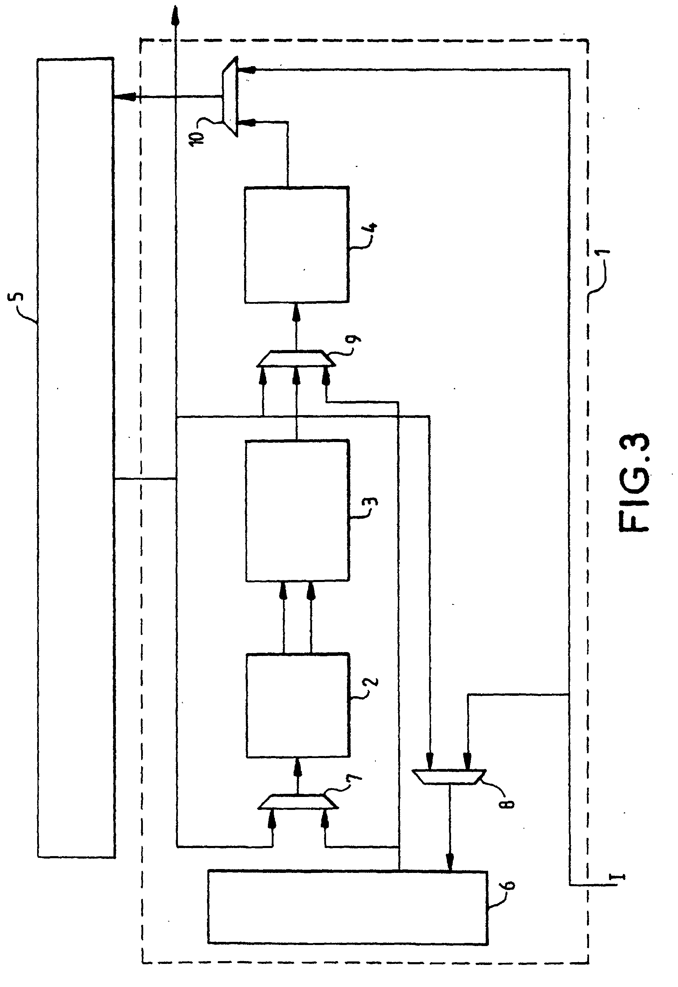

La figure 3 est un diagramme bloc du dispositif selon le présent exemple de réalisation.

Un circuit 1 comporte en série, pour les besoins de la correction d'erreur proprement dite, un générateur de syndromes 2, un résolveur d'équations 3 et un correcteur 4.

Une mémoire vive 5 externe au circuit 1, par exemple du type SRAM, sert à stocker certains paquets de données brutes à corriger et les données corrigées. Une mémoire vive interne 6, utilisée uniquement en mode CD, est destinée à stocker des résultats de décodage intermédiaire. Ceci évite avantageusement un accès trop fréquent à la mémoire externe 5.

Le circuit 1 comporte en outre quatre multiplexeurs qui, selon leur état, définissent le mode de fonctionnement CD ou le mode de fonctionnement DVD, ainsi que les diverses étapes dans le cadre de chaque mode. Un premier multiplexeur 7 sélectionne, à l'entrée du générateur de syndromes 2, soit les données en provenance de la SRAM 5, soit les données en provenance de la mémoire 6. Un second multiplexeur 8 sélectionne à l'entrée de la mémoire 6 soit les données en provenance de la SRAM 5, soit les données entrantes en provenance de l'extérieur du circuit (ligne I sur la figure 3). Un troisième multiplexeur 9 sélectionne, à l'entrée du correcteur 4, soit des données en provenance de la SRAM 5, soit des données en provenance de la mémoire 6, soit des données en provenance du résolveur d'équations 3. Un quatrième multiplexeur 10 alimente la SRAM 5, soit par des données corrigées en provenance du correcteur 4, soit par des données entrantes (I).

La mémoire 5 est utilisée pour stocker les blocs de type DVD, les drapeaux d'erreur ou d'effacements associés à ces blocs avant ou après une passe de correction, les blocs C2 de type CD dans un but d'entrelacement avant correction, des drapeaux d'erreur qui y sont associés, les blocs C1 corrigés et diverses données de synchronisation.

Chaque passe de correction d'erreur Reed-Solomon effectuée par le circuit 1 peut être résumée comme suite, que ce soit en mode CD ou DVD.

**Etape 1.** Calcul des syndromes $S_j$, du polynôme d'effacement $E(z)$ et du syndrome modifié $T(z)$ :

$$S(z) = \sum_{j=0}^{r-1} S_j z^j$$

où r est le nombre de symboles de parité dans un mot de code, et où

$$S_j = \sum_{i=0}^{n-1} r_i \alpha^{ij} \quad (1)$$

où n est le nombre de symboles d'un mot de code, où les coefficients $r_i$ sont tels que $r(z) = r_{n-1} \cdot z^{n-1} + r_{n-2} \cdot z^{n-2} +...+r_0$ où $r(z)$ est un mot de code reçu, et où $\alpha^i$ est une racine de $g(z)$, polynôme générateur,

$$E(z) = \prod_{k=1}^{e} (1 - z\alpha^{Jk}) \quad (2)$$

où $\alpha^{Jk}$ est la position d'un effacement k et où e est le nombre d'effacements,

$$T(z)=S(z)E(z) \bmod z^{2t} \tag{3}$$

où t est un paramètre du code RS.

Remarque: le paramètre t dépend de la correction en cours. C'est le nombre de syndromes à calculer pour chaque mot de code. Il est égal au nombre de symboles de parité dans le mot de code à corriger: 4 et 4 pour les deux codages C1 et C2 du disque compact, 10 et 16 pour les codages interne et externe du DVD.

**Etape 2.** Mettre en oeuvre l'algorithme d'Euclide étendu pour calculer le polynôme de localisation d'erreur $\Lambda(z)$ et le polynôme d'évaluation d'erreur $\Omega(z)$, et calculer le nouveau polynôme de localisation d'erreur $\Psi(z)$, où

$$\Psi(z)=\Lambda(z)E(z) \bmod z^{2t} \tag{4}$$

**Etape 3.** Mettre en oeuvre l'algorithme de Chien pour déterminer les racines du polynôme de localisation d'erreur. Les racines de ce polynôme indiquent les positions des erreurs et des effacements dans les symboles reçus Mettre en oeuvre l'algorithme de Forney pour déterminer les valeurs des erreurs et des effacements à partir des racines du polynôme de localisation d'erreur, de la dérivée du polynôme de localisation d'erreur et du polynôme d'évaluation d'erreur.

**Etape 4.** Vérifier le processus de décodage et corriger les symboles reçus.

Les algorithmes mentionnés sont, en soi, connus par ailleurs. On se référera notamment à l'ouvrage 'Reed-Solomon Codes and their Applications', édité par S.B. Wicker et V.K. Bhagarva, IEEE Press 1994, en ce qui concerne des implémentations de l'algorithme d'Euclide et les algorithmes de Chien et de Forney, et de manière générale, la théorie mathématique des codes Reed-Solomon. Il existe d'ailleurs dans la littérature d'autres algorithmes pour réaliser certaines des étapes.

Dans ce qui suit, on décrira dans un premier temps le fonctionnement du dispositif dans chaque mode, DVD ou CD, puis dans un deuxième temps, on s'attachera à décrire plus en détail l'implémentation matérielle de certains aspects du décodeur Reed-Solomon, en particulier le résolveur d'équations 3.

- Décodage DVD

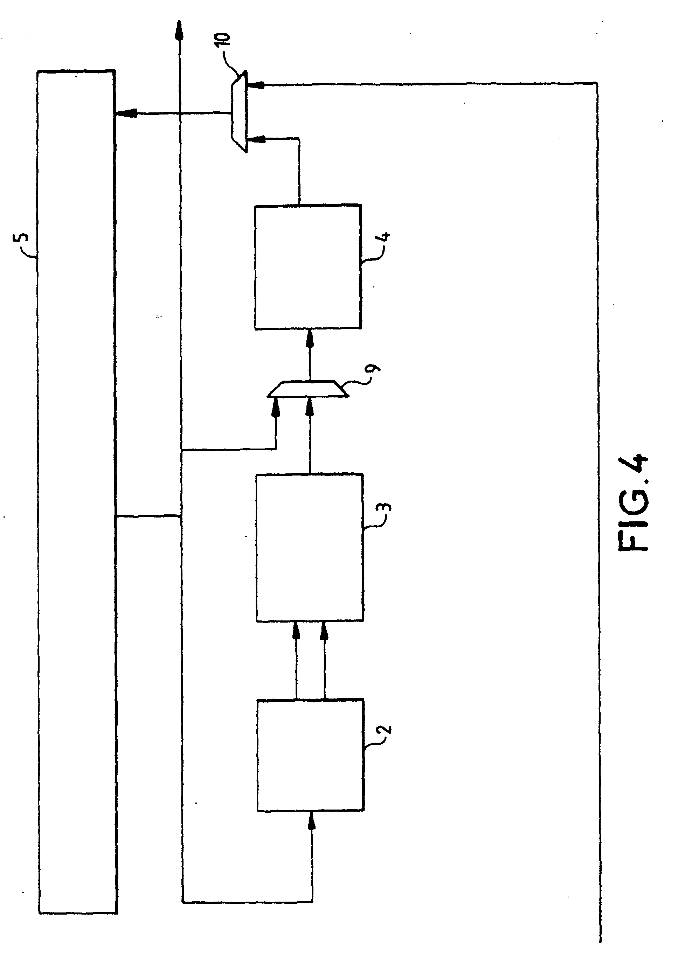

Le fonctionnement en mode DVD est illustré par la figure 4. Par rapport au schéma général de la figure 3, les parties du circuit 1 non concernées par le fonctionnement en mode DVD ont été effacées.

(a) Code interne (PI) - Première passe

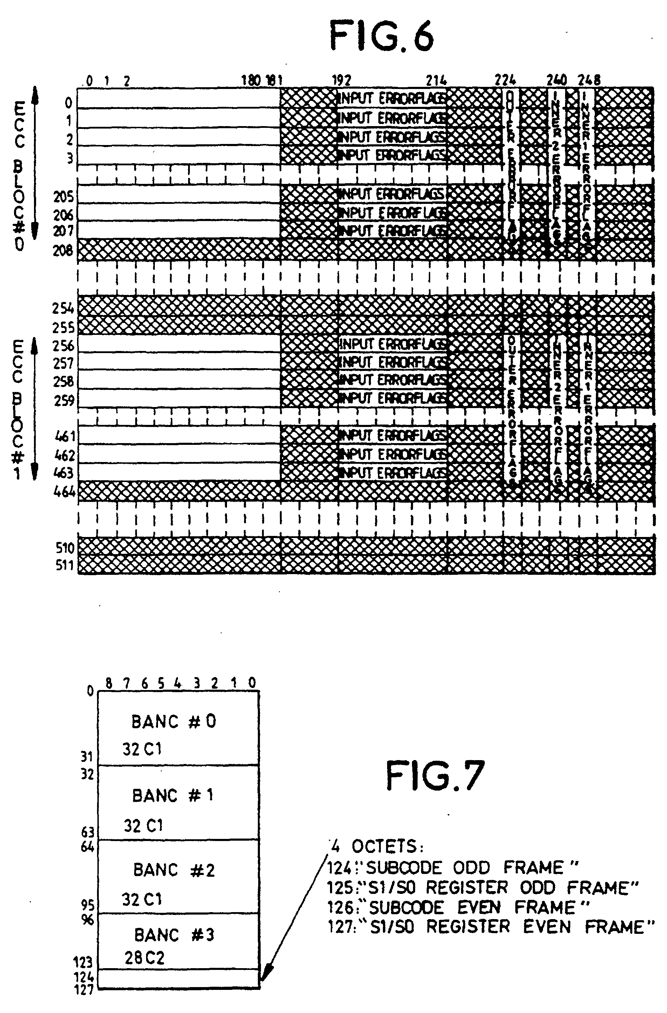

Les données entrantes sont stockées dans un premier temps dans la SRAM 5, en transitant par le multiplexeur 10. La figure 6 montre la façon dont les blocs sont stockés dans la SRAM 5. Ces données sont composées de deux blocs de 208*182 octets. Chaque bloc est accompagné de 208*23 octets d'effacement. Chaque bit d'effacement indique pour un symbole d'un bloc si ce symbole est à considérer comme sûr ou non. Cette information est utilisée ensuite au cours de la correction d'erreur Reed-Solomon. Ces bits d'effacement sont déterminés de façon connue en soi par un ensemble extérieur au circuit 1. Selon le présent exemple de réalisation, cet ensemble extérieur vérifie la présence de la donnée dans une table de démodulation numérique.

Dans un premier temps, le circuit procède au décodage du code RS interne PI. Le bloc de données ou symboles, ainsi que les bits d'effacement sont lus ligne par ligne dans la SRAM 5 et transférés au générateur de syndromes 2. Celui-ci détermine pour chaque ligne (chaque mot de code) le polynôme S(z) et le polynôme d'effacement E(z), tels que définis précédemment.

Pratiquement, les syndromes Sj sont calculés de la façon suivante :

$$Sj = \sum_{i=0}^{n-1} r_i \, T^{ij}$$

où T est la matrice associée au polynôme générateur G(z). Selon le présent exemple, $G(z) = z^8 + z^4 + z^3 + z^2 + 1$. Dans ce cas, la matrice T est :

$$
\begin{bmatrix}
0 & 0 & 0 & 0 & 0 & 0 & 0 & 1 \\
1 & 0 & 0 & 0 & 0 & 0 & 0 & 0 \\
0 & 1 & 0 & 0 & 0 & 0 & 0 & 1 \\
0 & 0 & 1 & 0 & 0 & 0 & 0 & 1 \\
0 & 0 & 0 & 1 & 0 & 0 & 0 & 1 \\
0 & 0 & 0 & 0 & 1 & 0 & 0 & 0 \\
0 & 0 & 0 & 0 & 0 & 1 & 0 & 0 \\
0 & 0 & 0 & 0 & 0 & 0 & 1 & 0
\end{bmatrix}
$$

Les calculs des Sj syndromes sont effectués par le générateur 2, à l'aide de j registres rebouclés chacun sur leur entrée respective à travers un multiplicateur par $T^n$ et un additionneur. Les syndromes Sj constituent les coefficients du polynôme S(z).

Dans le cas du décodage DVD, chaque ligne transférée comporte donc 182 octets de données, chaque octet représentant un symbole, ainsi que 182 bits d'effacement, un pour chaque symbole. Le code interne PI étant constitué de 10 symboles de correction, 10 syndromes sont calculés. Le générateur 2 détermine également à partir des bits d'effacement les coefficients Ej du polynôme d'effacement E(z) et les stocke dans un registre approprié.

S'il y a plus de dix effacements dans une ligne, la correction n'est pas possible et le mot de code est marqué comme erroné. L'état erroné d'un mot de code est inscrit dans la mémoire SRAM (Figure 6), sous la forme d'un bit ('Inner 1 Error Flag').

Les coefficients de S(z), et le cas échéant de E(z), sont transmis au résolveur d'équations 3.

Si un polynôme d'effacement E(z) existe (au moins un effacement), alors le circuit 3 calcule le polynôme T(z), produit de E(z) par S(z), puis met en oeuvre l'algorithme étendu d'Euclide pour déterminer en même temps le polynôme de localisation d'erreur Λ(z) et le polynôme d'évaluation d'erreur Ω(z).

Si aucun effacement n'existe, alors la détermination de Ω(z) et de Λ(z) est effectuée directement à partir de S(z) (en ce qui concerne les calculs, on prendra dans ce cas E(z)=1).

Le circuit 3 détermine également, le cas échéant, Ψ(z).

La structure et le fonctionnement du circuit 3 seront vus en détail plus loin.

Le correcteur 4 exécute de façon connue les algorithmes de Chien et Forney.
Ce correcteur disposera donc finalement des données suivantes :

- les positions des erreurs dans le mot de code traité,
- les valeurs de ces erreurs,
- le nombre d'effacements.

Les erreurs dans le mot de code sont corrigés en conséquence. Pour ce faire, le circuit correcteur 4 (figure 4) lit le mot de code à corriger dans la mémoire SRAM 5 et les positions et valeurs des erreurs à partir du circuit 3. Le correcteur 4 inscrit le mot de code corrigé dans la SRAM 5, à l'emplacement du mot de code initial. Les multiplexeurs 9 et 10 sont commandés en conséquence. Si la capacité du code RS est dépassée, le correcteur inscrit un drapeau d'indication d'erreur (Référence 'Inner 1 Error Flags' de la figure 6).

(b) Code externe (PO)

Le dispositif réalise ensuite une seconde correction sur la base du code PO. En fonction du résultat pour chaque mot de code vertical, un drapeau d'erreur est mis à une valeur appropriée (Référence 'Outer Error Flag' de la figure 6).

(c) Code interne (PI) - Seconde passe

Une fois la correction PO réalisée, une seconde correction horizontale est effectuée sur la base du code interne PI. Certains mots qui n'étaient pas corrigibles lors de la première passe peuvent l'être devenus suite à la correction de certains symboles de ces mots lors de la correction à base du code PO. Le cas échéant, des drapeaux d'erreur (Référence 'Inner 2 Error Flag' de la figure 6) sont mis à la valeur appropriée.
Cette dernière passe peut être optionnelle.

- Décodage CD

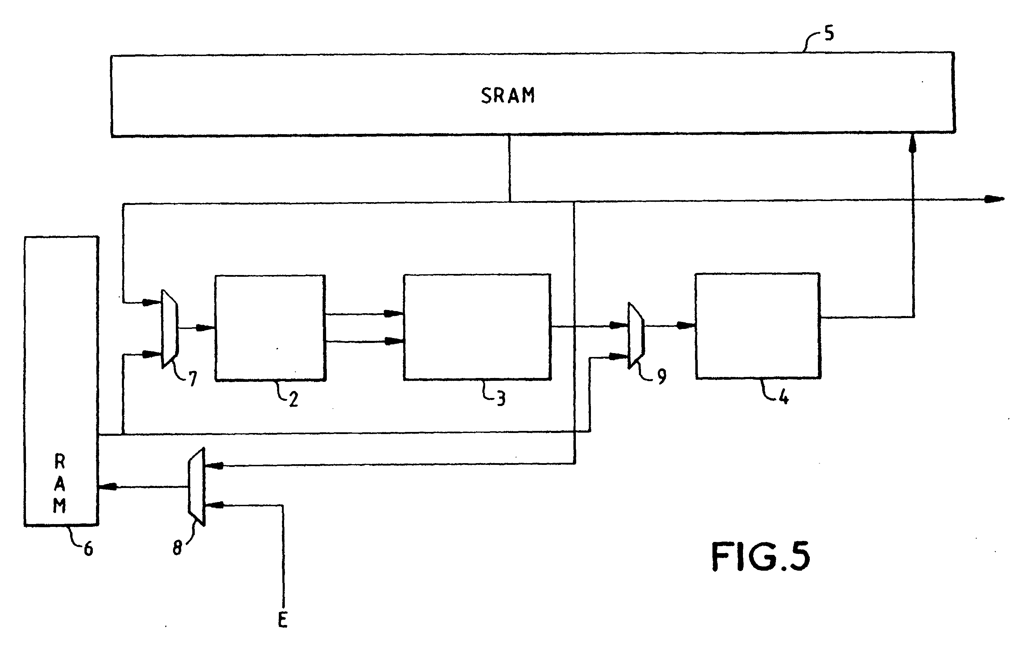

Le fonctionnement en mode CD est illustré par la figure 5. Par rapport au schéma général de la figure 3, les parties du circuit 1 non concernées par le fonctionnement en mode CD ont été effacées.
Dans un premier temps, les données à corriger (blocs C1 de 32 symboles) sont inscrites dans la mémoire vive interne 6 à travers l'entrée E. La figure 7 illustre la façon dont les données sont inscrites dans cette mémoire 6. La mémoire 6 comporte de l'espace pour trois blocs de 32 symboles chacun. Les blocs C1 sont entrelacés lorsqu'ils sont stockés dans la mémoire 6. Etant donné la nature de l'entrelacement, deux blocs sont nécessaires pour obtenir un mot de code C1. L'emplacement du troisième bloc est utilisé pour l'écriture du bloc C1 suivant, cette écriture ayant lieu pendant la correction d'un bloc précédent. 28 emplacements de la mémoire 6 sont réservés à un mot de code de 28 symboles (code C2). Quatre emplacements sont réservés à d'autres informations, ce qui donne à la mémoire une longueur de 128 mots. La mémoire possède une largeur de 9 bits, 8 bits étant destinés à stocker des symboles, le neuvième indiquant les effacements. Initialement, les bits d'effacement indiquent si les symboles stockés sont valides ou non valides.
Le générateur de syndromes 2 lit un premier mot de code désentrelacé dans la mémoire 6, ainsi que les bits d'effacement correspondants. Les traitements effectués par le circuit 2, ainsi qu'ensuite par le résolveur 3, sont similaires à ceux du mode DVD, étant entendu que les paramètres du code Reed-Solomon ne sont pas les mêmes. Le principe de la correction est cependant identique.
L'emplacement des erreurs et leur valeur sont communiqués par le résolveur 3 au correcteur 4. Ce dernier reçoit de la RAM 6 tous les symboles du mot de code, en dehors des symboles de parité C1. Si une correction est nécessaire, alors le symbole erroné est remplacé par le symbole corrigé. Les symboles sont ensuite stockés dans la mémoire 5. Il est à noter que dans cette 'correction à la volée', tous les symboles transitent de la mémoire RAM 6 par le correcteur 4 vers la mémoire 5, tandis que dans le mode DVD, seuls les symboles à corriger transitent de la mémoire 5 à travers le correcteur et de nouveau vers la mémoire 5.
Cette architecture est basée sur la reconnaissance du fait que les mots de code en mode CD (28 ou 32 symboles) sont bien plus courts qu'en mode DVD (182 ou 208 symboles). Une correction à la volée est réalisée seulement sur les mots de code 'courts', et cela à partir de la mémoire rapide 6, car tous les symboles d'un mot de code doivent alors transiter par le correcteur. Une telle correction à la volée sur de longs mots de code exigerait plus de cycles de la part du correcteur 4, ainsi que la mise en oeuvre d'une mémoire 5 beaucoup plus rapide et par conséquent plus coûteuse si les mots de code à corriger de cette façon y étaient stockés.
Cette architecture permet par conséquent d'utiliser une mémoire 5 du commerce, celle-ci étant disposée hors du composant comportant le dispositif décrit ici, et de prévoir sur le composant lui-même une mémoire interne, de taille faible donc peu coûteuse. Ceci vaut pour le cas où la mémoire 5 est implémentée sur un composant autre que la mémoire 6.

Il est clair que l'évocation de mémoires 'externe' ou 'interne' n'exclut pas l'application de ce qui est décrit à un circuit intégré comportant à la fois la mémoire 5 et la mémoire 6. La mémoire 5 doit être vue comme une mémoire de masse, tandis que la mémoire 6 comme une mémoire cache.

L'entrelacement des symboles des mots de code C2 est tel que les 28 symboles d'un même mot de code sont répartis parmi 112 blocs de 32 symboles. A chaque correction de code C1 correspond une correction de code C2. Ainsi, le système ne sera correctement initialisé qu'après 112 trames. De plus, pour pouvoir effectuer le désentrelacement du code C2, après la correction de code C1, les symboles sont stockés dans la mémoire 5, de plus grande capacité que la mémoire 6 et sont relus pour être, d'une part, inscrits dans la mémoire 6 et, d'autre part, fournis directement au générateur de syndromes 2.

L'inscription dans la mémoire 6 est nécessaire pour la correction du mot de code par le correcteur 4 'à la volée', car comme mentionné à propos de la correction C1, dans le mode CD, le correcteur lit les mots de code à corriger non pas dans la mémoire SRAM 5, mais dans la mémoire vive 6.

Le processus de correction C2 est similaire à ce qui a déjà été exposé pour la correction C1. Suite à la correction à la volée, les symboles corrigés sont stockés dans la mémoire 5, sans toutefois les symboles de parité du code C2.

<u>- Résolveur d'équations - Détermination de $\Omega(z)$ et de $\Lambda(z)$</u>

La suite de la description concerne l'implémentation du résolveur d'équations.

La tâche principale du résolveur d'équations (dénommé aussi 'Key Equation Solver' en langue anglaise) est de déterminer les polynômes de localisation et d'évaluation d'erreur, respectivement $\Lambda(z)$ et $\Omega(z)$.

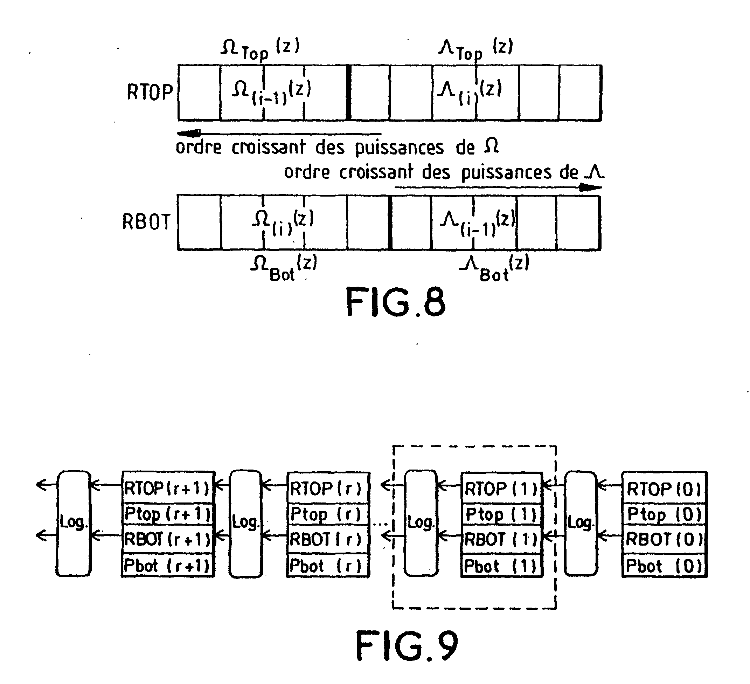

La détermination de $\Omega(z)$ et de $\Lambda(z)$ est effectuée en mettant en oeuvre l'algorithme étendu d'Euclide. On met en oeuvre pour cela deux registres de polynômes, respectivement RTOP et RBOT, illustrés par la figure 8.

L'algorithme d'Euclide étendu est le suivant :

Les polynômes $\Omega(z)$ et $\Lambda(z)$ satisfont l'équation :

$$\Lambda(z) \cdot S(z) = \Omega(z) \bmod z^r$$

$$\deg \text{ ré}\Omega(z) < \deg \text{ ré}\Lambda(z)$$

(La variable 'r' est égale au nombre de symboles de parité d'un mot de code (capacité de correction du code), c'est à dire à 2t).

On prend comme valeurs initiales :

$$\Lambda_{-1}(z) = 0$$

$$\Lambda_0(z) = 1$$

$$\Omega_{-1}(z) = Z^r$$

$$\Omega_0(z) = T(z)$$

(On prendra $\Omega_0(z) = S(z)$ dans le cas où aucun effacement n'est connu).

On réalise les itérations suivantes jusqu'à ce que

$$\deg \text{ ré}\Omega_n(z) < \deg \text{ré}\Lambda_n(z)$$

$$\Omega_n(z) = \Omega_{n-2}(z) \bmod \Omega_{n-1}(z) \quad (A)$$

$$\Lambda_n(z) = \Lambda_{n-1}(z)^* Q_n(z) + \Lambda_{n-2}(z) \quad (B)$$

$$Q_n(z) = \Omega_{n-2}(z) \operatorname{div} \Omega_{n-1}(z) \quad (C)$$

Les registres polynomiaux RTOP et RBOT comportent chacun r+1 registres (RTOP(k) et RBOT(k)) de 8 bits, appelés registres de symboles. Chacun de ces registres de symboles stocke un coefficient d'un des polynômes $\Lambda(z)$ ou $\Omega(z)$. Chaque registre RTOP et RBOT est séparé en une partie dite partie A et une partie dite $\Omega$, de droite à gauche.

Initialement, le degré de $\Omega(z)$ est maximal et le degré de $\Lambda(z)$ est minimal. Dans les registres RTOP et RBOT, les degrés de $\Omega(z)$ augmentent vers la gauche, tandis que les degrés de $\Lambda(z)$ augmentent vers la droite, à partir du point de séparation entre les parties $\Lambda$ et $\Omega$.

Le tableau 1 illustre le contenu des registres en phase initiale de l'itération.

| Rang de registre / cellule | r+1 | r | ... | 2 | 1 | 0 |
|---|---|---|---|---|---|---|

| RBOT | 1 | 0 | 0 | 0 | 0 | 1 |
|---|---|---|---|---|---|---|
| Pbot | 0 | 0 | 0 | 0 | 0 | 1 |
| RTOP | $T_{r-1}$ | $T_{r-2}$ | ... | $T_0$ | 0 | 0 |
| Ptop | 0 | 0 | ... | 0 | 1 | 1 |

Tableau 1

Les drapeaux Ptop et Pbot indiquent pour chaque registre de symbole si ce registre comporte un coefficient de $\Omega(z)$ (Ptop/Pbot=0) ou de $\Lambda(z)$ (Ptop/Pbot=1).

On définit par ailleurs 'DegTop' et 'DegBot' comme étant les degrés des parties $\Omega$ de RTOP et RBOT respectivement, ainsi que la variable 'ratio', qui désigne le rapport RTOP(r+1)/RBOT(r+1).

L'algorithme étendu d'Euclide se traduit dans ce contexte par :

```
DegBot=r, DegTop=r-1
TANT QUE (DegTop>=t) FAIRE
        SI ratio <> 0 ET (DegTop<DegBot)
                ECHANGER RTOP, RBOT
                ECHANGER DegTop, DegBot
                ECHANGER Ptop, Pbot
        FIN SI
        POUR k=r JUSQU'A 0
                SI (Pbot(k)=Ptop(k)=1) ALORS
                        RBOT(k)=RBOT(k)+ratio*RTOP(k)
                        RTOP(k+1)=RTOP(k)
                SINON SI (Pbot(k)=Ptop(k)=0) ALORS
                        RTOP(k+1)=RTOP(k)+ratio*RBOT(k)
                SINON
                        RTOP(k+1)=RTOP(k)
                FIN SI
                        Ptop(k+1)=Ptop(k)
```

FIN POUR
DegTop=DegTop-1
FIN TANT QUE

Lorsqu'il faut prendre en compte des effacements, la condition du TANT QUE devient DegTop>=m, où m=t+ (degréE(z)/2).

L'indice k désigne une cellule d'ordre k et les registres qui y sont contenus.

On définit r+1 cellules, chaque cellule comprenant les deux registres de symboles de RTOP et RBOT ayant le même rang. Chaque cellule doit également effectuer les opérations définies ci-dessus.

La figure 9 est un schéma illustrant la connexion des r+1 cellules pour former les registres RTOP et RBOT. Le rectangle en tirets identifie une cellule de base, qui comprend les différents registres, multiplexeurs, additionneurs et le multiplieur nécessaire pour l'implémentation de l'algorithme.

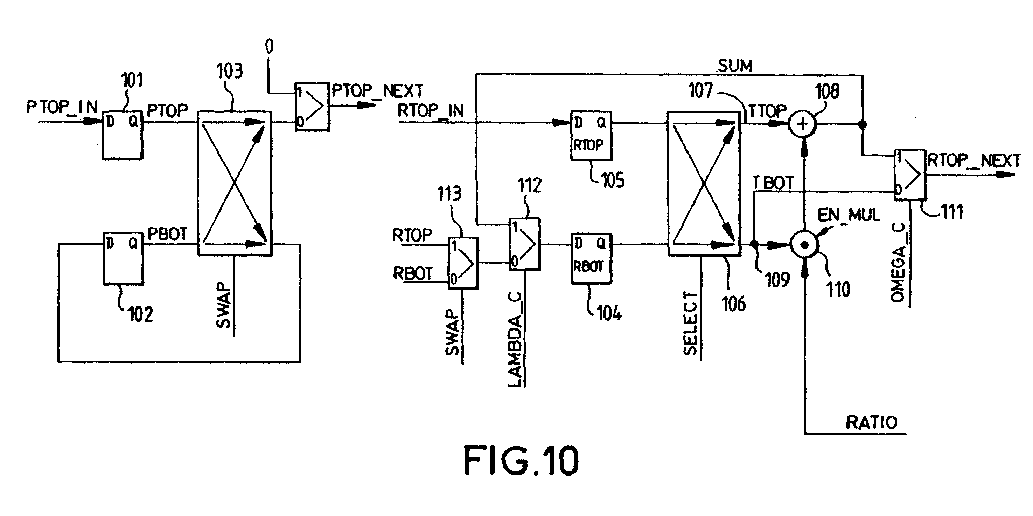

La figure 10 est un diagramme fonctionnel d'une cellule.

La cellule comporte un registre à 1 bit 101 destiné à stocker le drapeau Ptop, ainsi qu'un registre à 1 bit 102, destiné à stocker le drapeau Pbot. Ces registres sont constitués chacun d'une bascule D commandée de façon appropriée. Un circuit d'inversion 103 possède deux entrées, connectées respectivement aux sorties non inversées Q des registres 101 et 102 (signaux Ptop et Pbot). Ce circuit d'inversion comporte deux sorties, dont la première, référencée Ptop_NEXT, est connectée à l'entrée du registre équivalent au registre 101 de la cellule suivante, et dont la seconde sortie reboucle sur l'entrée D du registre 102. Selon la valeur d'un signal de commande SWAP, Pbot est transmis à la première sortie et Ptop à la seconde, ou inversement.

La cellule comporte également deux registres à 8 bits, référencés 104 et 105, faisant partie respectivement du registre RBOT et RTOP. Ces registres sur 8 bits sont formés par exemple de 8 registres à 1 bit connectés en parallèle. Les sorties respectives des registres 104 et 105 sont connectées chacune à une entrée d'un circuit inverseur 106, commandé par un signal SELECT.

Le circuit inverseur 106, à l'image du circuit inverseur 103, connecte chaque entrée soit à l'une, soit à l'autre de ses sorties, selon l'état du signal SELECT. La première sortie 107 du circuit inverseur 106 est reliée à une entrée d'un additionneur 108. La seconde sortie 109 du circuit inverseur 106 est reliée à un multiplieur 110, qui multiplie la valeur présente à la sortie 109 par la variable 'ratio'. La sortie du multiplieur 110 est reliée à une entrée de l'additionneur 108.

Le registre 105 reçoit sur son entrée D un signal RTOP_IN, qui correspond à la sortie du registre à 8 bits de RTOP de la cellule précédente.

Le signal de sortie de la cellule vers la prochaine cellule est référencé RTOP_NEXT. Cette sortie est constituée par la sortie d'un multiplexeur 111, qui sélectionne, selon la valeur d'un signal de commande référencé OMEGA_C, soit la sortie de l'additionneur 108, soit la seconde sortie 109 du circuit inverseur 106.

En dernier lieu, l'entrée du registre RBOT 104 est reliée par l'intermédiaire d'un second multiplexeur 112, selon la valeur d'un signal de commande référencé LAMBDA_C, soit à la sortie du l'additionneur 108, soit à la sortie d'un troisième multiplexeur 113. Ce troisième multiplexeur sélectionne, selon la valeur du signal de commande SWAP, soit la contenu du registre 104 (RBOT), soit celui du registre 105 (RTOP).

Les signaux de commande sont élaborés de la façon suivante :

LAMBDA_C = Pbot AND Ptop
OMEGA_C = NOT (Pbot OR Ptop)
SELECT = NOT (SWAP XOR OMEGA_C)
EN_MUL = (LAMBDA_C OR OMEGA_C)

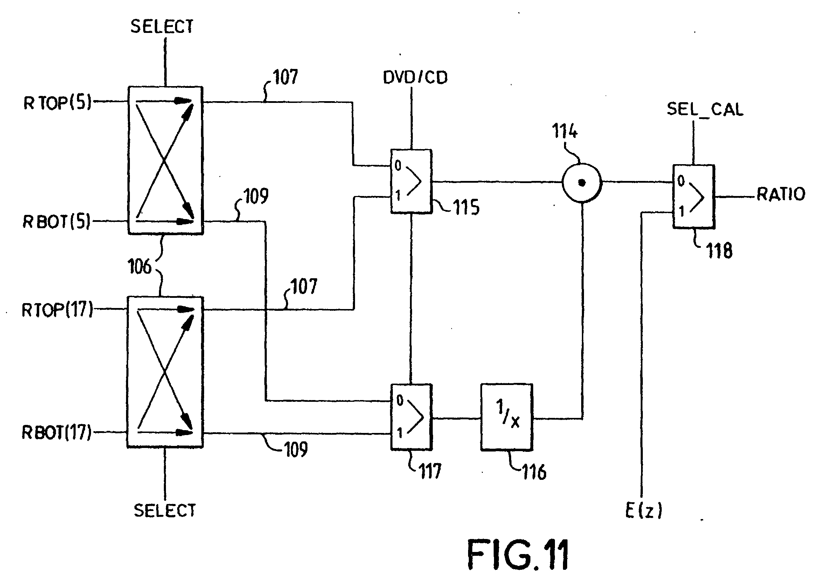

La figure 11 représente l'extrémité des cellules constitutives des registres RTOP et RBOT. Cette extrémité sert à calculer la variable ratio. Sur cette figure 11, il est représenté les circuits inverseurs 106 des cellules de poids 5 et 17 sur lesquels on récupère soit RTOP(5) et RBOT(5), soit RTOP(17) et RBOT(17). Bien évidemment, le signal SELECT inverse les données RTOP et RBOT, s'il y a lieu.

Un circuit de multiplication 114, disposant de deux entrées et d'une sortie, permet d'effectuer un produit entre deux éléments du corps de Galois. Le circuit de multiplication 114 a l'une de ses entrée connectée à l'une des sorties 107 provenant soit de la cellule de poids 5 soit de la cellule de poids 17 par l'intermédiaire d'un quatrième multiplexeur 115 en fonction d'un signal DVD/CD qui indique le mode de fonctionnement.

Un circuit d'inversion 116, disposant d'une entrée et d'une sortie, effectue une inversion d'élément du corps de Galois. Ce circuit d'inversion 116 est constitué de portes logiques réalisant des équation telles que à un élément $\alpha_i$, on associe un élément $\alpha_p$ tel que $\alpha_i * \alpha_p = 1$. L'entrée du circuit d'inversion 116 est connectée à l'une des sorties 109 provenant soit de la cellule de poids 5, soit de la cellule de 17 par l'intermédiaire d'un cinquième multiplexeur 117 en fonction du signal DVD/CD. La sortie du circuit d'inversion 116 est connectée à l'autre entrée du circuit de multiplication 114, de sorte que la sortie du circuit de multiplication 114 fournisse soit RTOP/RBOT, soit RBOT/RTOP en fonction du signal SELECT. Le signal DVD/CD permet de sélectionner les cellules concernées suivant que l'on travaille en mode CD ou en mode DVD.

Le signal ratio est fourni par l'intermédiaire d'un sixième multiplexeur 118 qui choisit entre la sortie du circuit de multiplication 114 et les éléments constitutifs du polynôme d'effacement E(z) en fonction d'un signal SEL_CAL. Le signal SEL_CAL est dans un premier état (par exemple 0) lorsque l'on réalisera l'algorithme étendu d'Euclide détaillé précédemment de sorte que la variable ratio sera égale à RTOP/RBOT ou RBOT/RTOP. Le signal SEL_CAL est dans un deuxième état (par exemple 1) lorsque l'on effectue le calcul du polynôme T(z) ou le calcul du polynôme de correction d'erreur $\Psi(z)$.

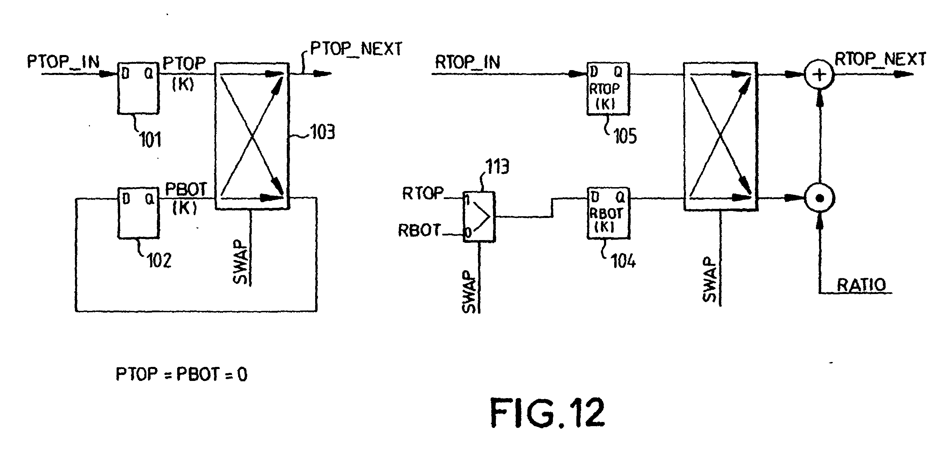

La figure 12 représente une cellule dans le cas où Ptop et Pbot sont égaux à 0. Les deux registres 104 et 105 de la cellule contiennent alors des coefficients de $\Omega(z)$. Cette configuration de la cellule est par conséquent dite configuration Omega.

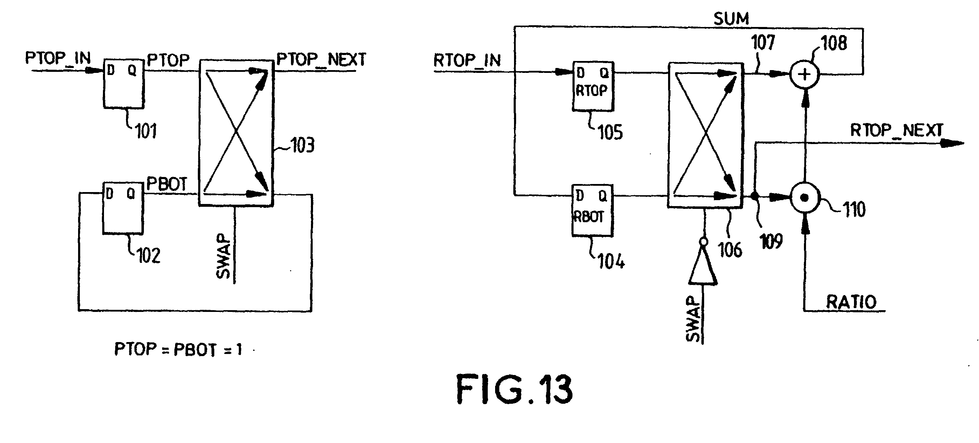

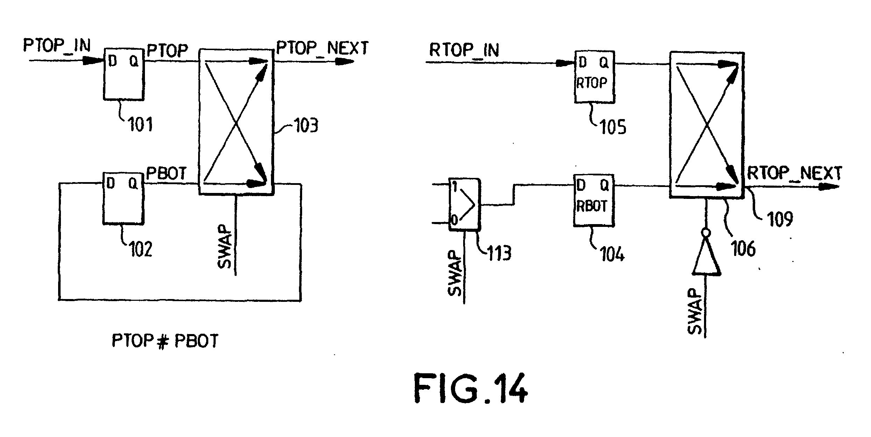

De manière similaire, les figures 13 et 14 représentent une cellule dans les cas respectifs où Ptop=Pbot=1 et Ptop est différent de Pbot, et sont appelées configurations Lambda et Mixte.

Tableau 2

| Type de cellule | SWAP = 0 | SWAP = 1 |
|---|---|---|
| Cellule Lambda | $Pbot_{t+1}(k)=P_tbot(k)$<br>$Ptop\_NEXT_{t+1}(k)=Ptop_t$<br>$(k)\ RBOT_{t+1}(k)=RBOT_t(k)+RTOP_t(k)*$<br>ratio<br>$RTOP\_NEXT_{t+1}(k)=RTOP_t(k)$ | $Pbot_{t+1}(k)=P_ttop(k)$<br>$Ptop\_NEXT_{t+1}(k)=Pbot_t(k)$<br>$RBOT_{t+1}(k)=RTOP_t(k)+RBOT_t(k)*$<br>ratio<br>$RTOP\_NEXT_{t+1}(k)=RBOT_t(k)$ |
| Cellule Omega | $Pbot_{t+1}(k)=P_tbot(k)$<br>$Ptop\_NEXT_{t+1}(k)=Ptop_t(k)$<br>$RBOT_{t+1}(k)=RBOT_t(k)$<br><br>$RTOP\_NEXT_{t+1}(k)=RTOP_t(k)$<br>$+RBOT_t(k)*ratio$ | $Pbot_{t+1}(k)=P_ttop(k)$<br>$Ptop\_NEXT_{t+1}(k)=Pbot_t(k)$<br>$RBOT_{t+1}(k)=RTOP_t(k)$<br><br>$RTOP\_NEXT_{t+1}(k)=RBOT_t(k)$<br>$+RTOP_t(k)*ratio$ |
| Cellule Mixte | $Pbot_{t+1}(k)=P_tbot(k)$<br>$Ptop\_NEXT_{t+1}(k)=Ptop_t(k)$<br>$RBOT_{t+1}(k)=RBOT_t(k)$<br>$RTOP\_NEXT_{t+1}(k)=RTOP_t(k)$ | $Pbot_{t+1}(k)=P_ttop(k)$<br>$Ptop\_NEXT_{t+1}(k)=Pbot_t(k)$<br>$RBOT_{t+1}(k)=RTOP_t(k)$<br>$RTOP\_NEXT_{t+1}(k)=RBOT_t(k)$ |

Les parties Lambda réalisent la multiplication de l'équation (B), tandis que les parties Omega réalisent la division de l'équation (C).

Si l'on prend comme exemple le polynôme S(z) tel que :

$$S(z) = \alpha^{14}z^5 + \alpha^{10}z^4 + \alpha^3z^3 + \alpha^7z^2 + \alpha^9z + \alpha^{12},$$

alors les conditions initiales sont :

$$\Lambda_{-1}(z) = 0$$

$$\Lambda_0(z) = 1$$

$$\Omega_{-1}(z) = Z^6$$

$$\Omega_0(z) = S(z)$$

Les tableaux 3 à 10 illustrent le contenu des cellules à la fin de chaque itération de l'algorithme.

Tableau 3

| (Conditions initiales) (DegBot=6 - DegTop=5 - ratio=$\alpha^{14}$ - SWAP=1) | | | | | | | | |
|---|---|---|---|---|---|---|---|---|
| **Rang** | **7** | **6** | **5** | **4** | **3** | **2** | **1** | **0** |
| **RBOT** | 1 | 0 | 0 | 0 | 0 | 0 | 0 | 1 |
| **Pbot** | 0 | 0 | 0 | 0 | 0 | 0 | 0 | 1 |
| **RTOP** | $\alpha^{14}$ | $\alpha^{10}$ | $\alpha^3$ | $\alpha^7$ | $\alpha^9$ | $\alpha^{12}$ | 0 | 0 |
| **Ptop** | 0 | 0 | 0 | 0 | 0 | 0 | 1 | 1 |

Tableau 4

| (Après SWAP) (DegBot=5 - DegTop=6 - ratio=$\alpha$ - SWAP=0) | | | | | | | | |
|---|---|---|---|---|---|---|---|---|
| **Rang** | **7** | **6** | **5** | **4** | **3** | **2** | **1** | **0** |
| **RBOT** | $\alpha^{14}$ | $\alpha^{10}$ | $\alpha^3$ | $\alpha^7$ | $\alpha^9$ | $\alpha^{12}$ | 0 | 1 |
| **Pbot** | 0 | 0 | 0 | 0 | 0 | 0 | 1 | 1 |
| **RTOP** | 1 | 0 | 0 | 0 | 0 | 0 | 0 | 1 |
| **Ptop** | 0 | 0 | 0 | 0 | 0 | 0 | 0 | 1 |

Tableau 5

| (Itération 1) (DegBot=5 - DegTop=5 - ratio=$\alpha^{12}$ - SWAP=0) | | | | | | | | |
|---|---|---|---|---|---|---|---|---|
| **Rang** | **7** | **6** | **5** | **4** | **3** | **2** | **1** | **0** |
| **RBOT** | $\alpha^{14}$ | $\alpha^{10}$ | $\alpha^3$ | $\alpha^7$ | $\alpha^9$ | $\alpha^{12}$ | 0 | $\alpha$ |
| **Pbot** | 0 | 0 | 0 | 0 | 0 | 0 | 1 | 1 |
| **RTOP** | $\alpha^{11}$ | $\alpha^4$ | $\alpha^8$ | $\alpha^{10}$ | $\alpha^{13}$ | 0 | 1 | 0 |
| **Ptop** | 0 | 0 | 0 | 0 | 0 | 0 | 1 | 1 |

Tableau 6

| (Itération 2) (DegBot=5 - DegTop=4 - ratio=$\alpha^3$ - SWAP=1) | | | | | | | | |
|---|---|---|---|---|---|---|---|---|
| **Rang** | **7** | **6** | **5** | **4** | **3** | **2** | **1** | **0** |
| **RBOT** | $\alpha^{14}$ | $\alpha^{10}$ | $\alpha^3$ | $\alpha^7$ | $\alpha^9$ | $\alpha^{12}$ | $\alpha^{12}$ | $\alpha$ |
| **Pbot** | 0 | 0 | 0 | 0 | 0 | 0 | 1 | 1 |
| **RTOP** | $\alpha^3$ | $\alpha^2$ | $\alpha^2$ | 1 | $\alpha^9$ | 1 | 0 | 0 |
| **Ptop** | 0 | 0 | 0 | 0 | 0 | 1 | 1 | 1 |

Tableau 7

| (Après SWAP) (DegBot=4 - DegTop=5 - ratio=$\alpha^{11}$ - SWAP=0) | | | | | | | | |
|---|---|---|---|---|---|---|---|---|
| **Rang** | **7** | **6** | **5** | **4** | **3** | **2** | **1** | **0** |
| **RBOT** | $\alpha^3$ | $\alpha^2$ | $\alpha^2$ | 1 | $\alpha^9$ | 1 | 0 | 0 |

Tableau 7   (suite)

| (Après SWAP) (DegBot=4 - DegTop=5 - ratio=$\alpha^{11}$ - SWAP=0) | | | | | | | |
|---|---|---|---|---|---|---|---|
| **Rang** | 7 | 6 | 5 | 4 | 3 | 2 | 1 | 0 |
| **Pbot** | 0 | 0 | 0 | 0 | 0 | 1 | 1 | 1 |
| **RTOP** | $\alpha^{14}$ | $\alpha^{10}$ | $\alpha^3$ | $\alpha^7$ | $\alpha^9$ | $\alpha^{12}$ | $\alpha^{12}$ | $\alpha$ |
| **Ptop** | 0 | 0 | 0 | 0 | 0 | 0 | 1 | 1 |

Tableau 8

| (Itération 3) (DegBot=4 - DegTop=4 - ratio=$\alpha^6$ - SWAP=0) | | | | | | | |
|---|---|---|---|---|---|---|---|
| **Rang** | 7 | 6 | 5 | 4 | 3 | 2 | 1 | 0 |
| **RBOT** | $\alpha^3$ | $\alpha^2$ | $\alpha^2$ | 1 | $\alpha^9$ | 1 | $\alpha^8$ | $\alpha^{12}$ |
| **Pbot** | 0 | 0 | 0 | 0 | 0 | 1 | 1 | 1 |
| **RTOP** | $\alpha^9$ | $\alpha^8$ | $\alpha^8$ | $\alpha^6$ | $\alpha^{12}$ | $\alpha^{12}$ | $\alpha$ | 0 |
| **Ptop** | 0 | 0 | 0 | 0 | 0 | 1 | 1 | 1 |

Tableau 9

| (Itération 4) (DegBot=4 - DegTop=3 - ratio=0 - SWAP=0) | | | | | | | |
|---|---|---|---|---|---|---|---|
| **Rang** | 7 | 6 | 5 | 4 | 3 | 2 | 1 | 0 |
| **RBOT** | $\alpha^3$ | $\alpha^2$ | $\alpha^2$ | 1 | $\alpha^9$ | $\alpha^{14}$ | $\alpha^{11}$ | $\alpha^{12}$ |
| **Pbot** | 0 | 0 | 0 | 0 | 0 | 1 | 1 | 1 |
| **RTOP** | 0 | 0 | 0 | $\alpha^{11}$ | $\alpha^{12}$ | $\alpha$ | 0 | 0 |
| **Ptop** | 0 | 0 | 0 | 0 | 1 | 1 | 1 | 1 |

Tableau 10

| (Itération 5) (DegBot=4 - DegTop=2 - ratio=0 - SWAP=0) | | | | | | | |
|---|---|---|---|---|---|---|---|
| **Rang** | 7 | 6 | 5 | 4 | 3 | 2 | 1 | 0 |
| **RBOT** | $\alpha^3$ | $\alpha^2$ | $\alpha^2$ | 1 | $\alpha^9$ | $\alpha^{14}$ | $\alpha^{11}$ | $\alpha^{12}$ |
| **Pbot** | 0 | 0 | 0 | 0 | 0 | 1 | 1 | 1 |
| **RTOP** | 0 | 0 | $\alpha^{11}$ | $\alpha^{12}$ | $\alpha$ | 0 | 0 | 0 |
| **Ptop** | 0 | 0 | 0 | 1 | 1 | 1 | 1 | 1 |

On obtient donc finalement :

$$\Lambda(z) = \alpha^{12}z^2 + \alpha^{11}z + \alpha^{14}$$

$$\Omega(z) = \alpha^{11}$$

Les coefficients de $\Lambda(z)$ sont stockés dans la partie Lambda de RBOT, tandis que les coefficients de $\Omega(z)$

sont stockés dans la partie Omega de RTOP.

Après le calcul de $\Lambda(z)$ et de $\Omega(z)$, il faut ajuster les coefficients de $\Omega(z)$ en rebouclant RTOP(r+1) sur RTOP (2) et en effectuant m=t+(degréE(z)/2) rotations.

Détermination de T(z) - syndrome modifié:

Avantageusement, le résolveur d'équations est également utilisé pour multiplier les polynômes E(z) et S(z) pour le calcul du syndrome modifié T(z). Le résolveur d'équations dispose déjà des multiplieurs nécessaires, car la détermination du polynôme $\Lambda(z)$ requiert une multiplication de polynômes. On met à profit ces ressources pour ce qui est de la multiplication E(z)*S(z), ce qui simplifie la constitution du générateur 2.

Le degré maximal de S(z) est 2t-1=r-1, tandis que celui de E(z) est 2t=r par construction (si le degré de E(z) est supérieur à 2t, le mot de code est marqué comme non corrigible). Le degré maximal de T(z) est donc r+1, ce qui correspond exactement au nombre de cellules du résolveur d'équations.

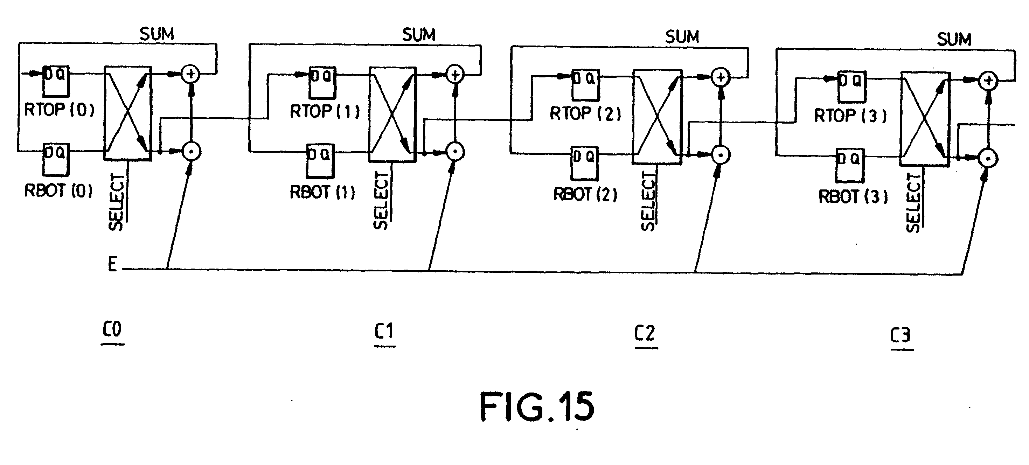

La figure 15 illustre la configuration d'une cellule pour la mise en oeuvre d'une multiplication. Les registres Ptop et Pbot servent à déterminer le contenu des registres RTOP(k) et RBOT(k). La configuration des cellules est assez proche de celle illustrée par le diagramme de la figure 13 (Ptop=Pbot=1), c'est à dire la configuration Lambda. Chaque registre RBOT reboucle sur son entrée à travers l'additionneur 108 associé, tandis que l'entrée de chaque registre RTOP est connecté à la sortie du registre RTOP de la cellule précédente. En dernier lieu, l'ensemble des multiplieurs des cellules sont connectés à une même entrée E, en vue de l'introduction des coefficients en série d'un des deux polynômes à multiplier. Dans le cadre du présent exemple, ce sont les coefficients de E(z) qui sont introduits par ce biais, mais on pourrait également introduire les coefficients de S(z). L'entrée E servait dans la configuration utilisée pour la détermination de $\Lambda(z)$ et de $\Omega(z)$ pour fournir la valeur de 'ratio' à chaque cellule.

Une autre différence avec la configuration Lambda de la figure 13 est que l'état du circuit inverseur 106 demeure identique tout au long de la multiplication.

Le principe de fonctionnement est le suivant :

Dans un premier temps, les coefficients de S(z) sont stockés dans les registres RTOP. Un '0' est présenté à l'entrée du premier registre RTOP(0).

Dans un second temps, les coefficients $E_i$ de E(z) sont présentés par ordre d'indice croissant à l'entrée E, à raison d'un coefficient par cycle d'horloge.

Le nombre de cycles d'horloge nécessaires pour effectuer la multiplication est égal au degré de E(z).

A titre d'exemple, le tableau 11 donne le contenu de chacun des registres dans le cas d'une multiplication de S(z) et de E(z) où S(z) est de degré 3 et E(z) de degré 3.

Tableau 11

| Cycle d'Horloge | Cellule Registre | 4 | 3 | 2 | 1 |
|---|---|---|---|---|---|
| | RBOT | 0 | 0 | 0 | 0 |
| | RTOP | $S_3$ | $S_2$ | $S_1$ | $S_0$ |
| **1** | RBOT | $S_3E_0$ | $S_2E_0$ | $S_1E_0$ | $S_0E_0$ |
| | RTOP | $S_2$ | $S_1$ | $S_0$ | 0 |
| **2** | RBOT | $S_3E_0+S_2E_1$ | $S_2E_0+S_1E_1$ | $S_1E_0+S_0E_1$ | $S_0E_0$ |
| | RTOP | $S_1$ | $S_0$ | 0 | 0 |
| **3** | RBOT | $S_3E_0+S_2E_1+S_1E_2$ | $S_2E_0+S_1E_1+S_0E_2$ | $S_1E_0+S_0E_1$ | $S_0E_0$ |
| | RTOP | $S_0$ | 0 | 0 | 0 |
| **4** | RBOT | $S_3E_0+S_2E_1+S_1E_2+S_0E_3$ | $S_2E_0+S_1E_1+S_0E_2$ | $S_1E_0+S_0E_1$ | $S_0E_0$ |
| | RTOP | 0 | 0 | 0 | 0 |

On voit que les registres RTOP(k) forment un registre à décalage servant uniquement à stocker les coefficients de S(z). Le registre à décalage est réalisé en choisissant correctement l'état des inverseurs 106. Les registres RBOT (k) servent d'accumulateurs respectifs pour chaque coefficient du polynôme T(z).

Chaque registre RBOT(k) contient donc finalement le coefficient $T_k$, où

$$T(z) = \sum_{k=1}^{r} T_k z^k \, .$$

Détermination du nouveau polynôme de localisation d'erreur $\Psi(z)$

Avantageusement, le résolveur d'équations est également utilisé pour multiplier les polynômes $E(z)$ et $\Lambda(z)$ pour le calcul de $\Psi(z)$. Ce dernier polynôme est calculé une fois $\Lambda(z)$ déterminé par le résolveur d'équations. Une fois que l'algorithme étendu d'Euclide a été mis en oeuvre, les coefficients de $\Lambda(z)$ sont stockés dans la partie Lambda de RBOT. Les autres registres RTOP(k) et RBOT(k) sont mis à zéro.

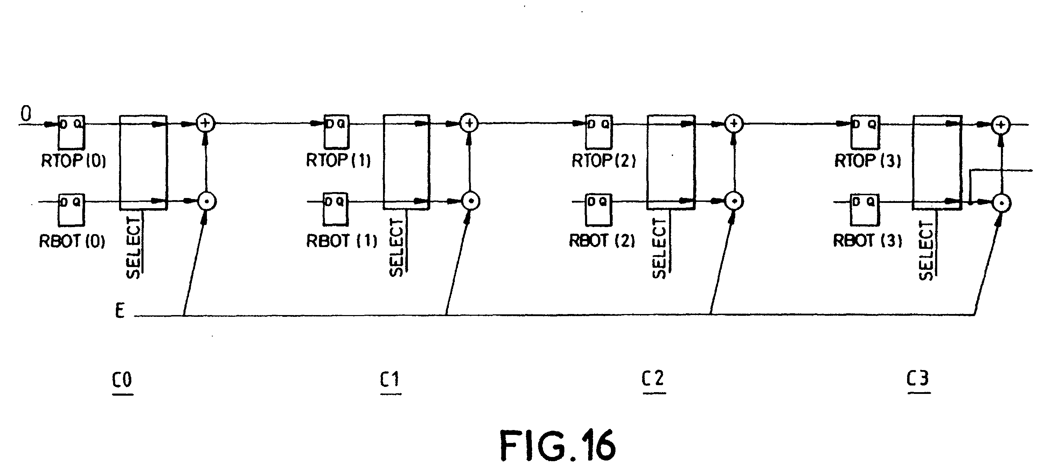

La configuration des cellules pour réaliser la multiplication est illustrée par le diagramme de la figure 16.

Les registres RTOP(k) sont connectés en série à travers les additionneurs des cellules. La valeur '0' est présentée à l'entrée du premier registre RTOP(0). La sortie de chaque registre RBOT(k) est connectée au multiplieur de sa cellule k. Les valeurs stockées dans les registres RBOT(k) ne changent pas pendant la présente multiplication. Comme dans la configuration de la figure 15, les entrées des multiplieurs autres que celles connectées à la sortie des registres RBOT(k) sont interconnectées (référence E).

Le degré de $\Lambda(z)$ est égal au nombre d'erreurs. Le degré de $E(z)$ est égal au nombre d'effacements.

Le tableau 12 donne le contenu des cellules après chaque cycle d'horloge.

Tableau 12

| Cycle | Cellule Registre | ... | 7 | 6 | 5 | 4 | 3 | 2 | 1 | 0 |
|---|---|---|---|---|---|---|---|---|---|---|
| | RBOT | 0 | 0 | 0 | 0 | 0 | 0 | $\Lambda_0$ | $\Lambda_1$ | $\Lambda_2$ |
| | RTOP | 0 | 0 | 0 | 0 | 0 | 0 | 0 | 0 | 0 |
| **1** | RBOT | 0 | 0 | 0 | 0 | 0 | 0 | $\Lambda_0$ | $\Lambda_1$ | $\Lambda_2$ |
| | RTOP | 0 | 0 | 0 | 0 | 0 | $\Lambda_0 E_0$ | $\Lambda_1 E_0$ | $\Lambda_2 E_0$ | 0 |
| **2** | RBOT | 0 | 0 | 0 | 0 | 0 | 0 | $\Lambda_0$ | $\Lambda_1$ | $\Lambda_2$ |
| | RTOP | 0 | 0 | 0 | 0 | $\Lambda_0 E_0$ | $\Lambda_1 E_0 + \Lambda_0 E_1$ | $\Lambda_2 E_0 + \Lambda_1 E_1$ | $\Lambda_2 E_1$ | 0 |
| **3** | RBOT | 0 | 0 | 0 | 0 | 0 | 0 | $\Lambda_0$ | $\Lambda_1$ | $\Lambda_2$ |
| | RTOP | 0 | 0 | 0 | $\Lambda_0 E_0$ | $\Lambda_1 E_0 + \Lambda_0 E_1$ | $\Lambda_2 E_0 + \Lambda_1 E_1 + \Lambda_0 E_2$ | $\Lambda_2 E_1 + \Lambda_1 E_2$ | $\Lambda_2 E_2$ | 0 |
| **4** | RBOT | 0 | 0 | 0 | 0 | 0 | 0 | $\Lambda_0$ | $\Lambda_1$ | $\Lambda_2$ |
| | RTOP | 0 | 0 | $\Lambda_0 E_0$ | $\Lambda_1 E_0 + \Lambda_0 E_1$ | $\Lambda_2 E_0 + \Lambda_1 E_1 + \Lambda_0 E_2$ | $\Lambda_2 E_1 + \Lambda_1 E_2 + \Lambda_0 E_3$ | $\Lambda_2 E_2 + \Lambda_1 E_3$ | $\Lambda_2 E_3$ | 0 |

Pendant le calcul de $\Psi(z)$, les multiplieurs restant actifs sont ceux des cellules pour lesquelles Pbot(k)=1.

Bien que le présent exemple de réalisation concerne la correction Reed-Solomon, la configuration de deux mémoires décrite peut être appliquée dans tous les cas où des paquets de données de longueur sensiblement différente doivent être corrigés.

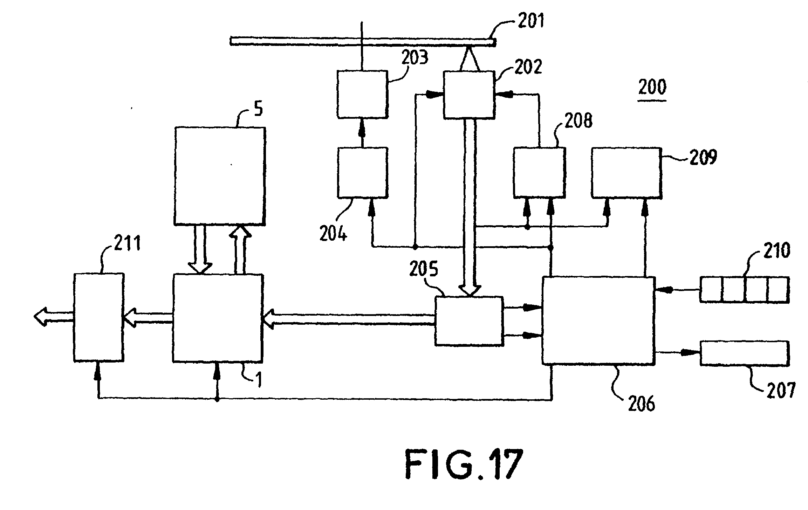

En dernier lieu, la figure 17 représente un lecteur 200 de disque optique 201 comportant le dispositif conforme à l'invention. Ce lecteur comporte un bloc optique 202 comportant de manière connue un laser, des moyens de focalisation, des détecteurs photoélectriques. Le lecteur comporte également un moteur 203 commandé par une unité d'asservissement 204. Les données lues par le bloc optique sont transmises à un démultiplexeur 205. Les données de contrôle sont transmises à un microprocesseur 206 commandant un affichage 207, l'asservissement de la focalisation 208 et le suivi de piste 209. Un clavier 210 permet à l'utilisateur de commander le lecteur.

Les paquets de données CD/DVD proprement dits sont transmis par le démultiplexeur 205 au dispositif de décodage 1 relié à la mémoire 5 et à une unité d'interpolation 211 qui fait office d'interface avec des convertisseurs numérique/analogique non illustrés.

Bien sûr, si un autre algorithme que l'algorithme étendu d'Euclide est utilisé, et que cet algorithme nécessite aussi des multiplications de polynômes, l'invention peut également s'appliquer.

# EP 1 076 933 B1

**Revendications**

1. Codeur décodeur de type Reed-Solomon comportant :

   - un générateur de syndromes (2) pour recevoir un flot de données et pour fournir un polynôme de syndrome (S(z)) et un polynôme d'effacement (E(z)) ;
   - des moyens d'implémentation (3) de l'algorithme d'Euclide, pour recevoir lesdits polynômes de syndrome (S(z)) et d'effacement (E(z)) et pour fournir un polynôme de localisation d'erreur ($\Psi$(z)) ;
   - des moyens de correction (4) pour corriger, le cas échéant, la ou les erreurs dans le flot de données à l'aide du polynôme de localisation d'erreur ($\Psi$(z)) ;

   et dans lequel les moyens d'implémentation (3) comportent des premier et deuxième registres (RTOP, RBOT) pour mémoriser deux polynômes intermédiaires de localisation et d'évaluation d'erreur ($\Lambda$(z), $\Omega$(z)), les registres (RTOP, RBOT) étant divisés en cellules élémentaires (104, 105) montées en série et comportant des moyens de multiplexage (106, 111, 112, 113) et de calcul (108, 110) **caractérisé en ce que** les cellules sont configurées de sorte que lors d'un cycle d'un signal d'horloge où une opération de calcul est réalisée alors il est possible simultanément d'inverser les données entre les deux registres.

2. Codeur-décodeur selon la revendication 1, **caractérisé en ce que** les moyens d'implémentation (3) sont agencés pour réaliser le produit du polynôme de localisation d'erreur ($\Lambda$(z)), et du polynôme d'effacement (E(z)) pour l'obtention du polynôme de localisation d'erreur ($\Psi$(z)).

3. Codeur-décodeur selon l'une des revendications 1 ou 2, **caractérisé en ce que** les moyens d'implémentation (3) sont agencés pour réaliser le produit du polynôme de syndromes (S(z)) par le polynôme d'effacement (E(z)).

4. Codeur-décodeur selon l'une des revendications 1 à 3, **caractérisé en ce que** les moyens d'implémentation (3) comportent r+1 cellules en série, r étant le nombre maximum de symboles redondants, chaque cellule comportant un premier registre (RTOP(k), 105) pour le stockage d'un coefficient de polynôme, un second registre (RBOT(k), 104) pour le stockage d'un coefficient de polynôme, un circuit (106) pour connecter le premier registre à une première entrée d'un additionneur (108) et le second registre à une première entrée d'un multiplieur (109) ou inversement, l'entrée du premier registre (105) étant connectée à une sortie d'une cellule précédente, l'entrée du second registre (104) étant connectée à des moyens de multiplexage (112, 113) dont les entrées sont connectées à la sortie du premier registre et du second registre de la cellule précédente et à la sortie de l'additionneur (108), la sortie de la cellule étant constituée par un multiplexeur (111) dont les entrées sont connectées à la sortie de l'additionneur et à la sortie du circuit (106) reliée à la première entrée du multiplieur, une seconde entrée de l'additionneur (108) étant connectée à la sortie du multiplieur (110), une seconde entrée du multiplieur (110) étant apte à recevoir un coefficient de multiplication.

5. Codeur-décodeur selon la revendication 4, **caractérisé en ce que** les secondes entrées des multiplieurs des cellules sont connectées.

6. Codeur-décodeur selon les revendications 3 à 5, **caractérisé en ce que** pour la multiplication des polynômes d'effacement (E(z)) et de syndromes (S(z)), la sortie du premier registre (RTOP(k), 105) d'une cellule est connectée au multiplieur (110), la sortie du second registre (RBOT(k), 104) est connectée à l'additionneur (108), la sortie de la cellule étant constituée par la première entrée du multiplieur, l'entrée du second registre (RBOT(k), 104) étant connectée à la sortie de l'additionneur (108).

7. Codeur-décodeur selon la revendication 6, **caractérisé en ce que** les coefficients d'un des deux polynômes à multiplier sont stockés dans les premiers registres des cellules (RTOP(k), 105) en phase d'initialisation, tandis que les coefficients de l'autre polynôme sont présentés un à un à la seconde entrée du multiplieur (110).

8. Codeur-décodeur selon les revendications 2, 4 et 5, **caractérisé en ce que** pour la multiplication des polynômes de localisation d'erreur ($\Lambda$(z)) et d'effacement (E(z)), le premier registre (RTOP(k), 105) d'une cellule est connecté à la sortie de l'additionneur de la cellule précédente (k-1), la sortie du premier registre étant connectée à la première entrée de l'additionneur (108), la sortie du second registre (RBOT(k), 104) étant connectée à la première entrée du multiplieur.

9. Codeur-décodeur selon la revendication 8, **caractérisé en ce que** les coefficients du polynôme de localisation ($\Lambda$

(z)) sont stockés dans les seconds registres (RBOT(k)) des cellules en phase d'initialisation, le contenu de ces second registres n'évoluant pas lors de la multiplication, les coefficients du polynôme d'effacement (E(z)) étant présentés un à un aux secondes entrées des multiplieurs (110) des cellules.

10. Lecteur (200) de disques optiques (201) **caractérisé en ce qu'**il comporte un codeur-décodeur selon l'une des revendications précédentes.


**Patentansprüche**

1. Koder-Dekoder vom Typ Reed-Solomon mit:

   - einem Syndrom-Generator (2) zum Empfang eines Datenstroms und zum Bilden eines Syndrom-Polynoms (S(z)) und eines Löschungs-Polynoms (E(z)),
   - Mitteln zur Durchführung (3) des euclidischen Algorithmus zum Empfang der Syndrom-Polynome (S(z)) und der Löschungs-Polynome (E(z)) und zur Lieferung eines Polynoms für die Fehlerortung ($\Psi$(z)),
   - Korrekturmitteln (4) um gegebenenfalls den oder die Fehler in dem Datenstrom mittels des Polynoms für die Fehlerlage ($\Psi$(z)) zu korrigieren,

   wobei die Mittel zur Durchführung (3) ein erstes und ein zweites Register (RTOP, RBOT) zum Speichern von zwei Zwischenpolynomen für die Ortung und die Auswertung des Fehlers ($\Lambda$ (z), $\Omega$(z)) enthalten, die Register (RTOP, RBOT) in elementare Zellen (104, 105) aufgeteilt sind, die in Reihe liegen und Mittel zum Multiplexing (106, 111, 112, 113) und zur Berechnung (108, 110) enthalten,
   **dadurch gekennzeichnet, dass**
   die Zellen derart konfiguriert sind, dass während eines Zyklus eines Taktsignals, wo ein Berechnungsvorgang erfolgt, es möglich ist, gleichzeitig die Daten zwischen den beiden Registern zu reversieren.

2. Koder-Dekoder nach Anspruch 1, **dadurch gekennzeichnet, dass** die Mittel zur Durchführung (3) dafür vorgesehen sind, das Produkt des Polynoms für die Fehlerortung ($\Lambda$ (z)) und des Löschungspolynoms (E(z)) zu erzeugen, um das Polynom für die Fehlerlage ($\Psi$ (z)) zu erhalten.

3. Koder-Dekoder nach einem der Ansprüche 1 oder 2, **dadurch gekennzeichnet, dass** die Mittel zur Durchführung (3) dafür vorgesehen sind, das Produkt des Syndrompolynoms (S(z)) mit dem Löschungspolynom (E(z)) zu bilden.

4. Koder-Dekoder nach einem der Ansprüche 1 bis 3, **dadurch gekennzeichnet, dass** die Mittel zur Durchführung (3) r+1 Zellen in Reihe enthalten, wobei r die Maximalzahl der redundanten Symbole ist, dass jede Zelle ein erstes Register (RTOP(k), 105) für die Speicherung eines Koeffizienten des Polynoms, ein zweites Register (RBOT(k), 104) für die Speicherung eines Koeffzienten des Polynoms, eine Schaltung (106) zum Verbinden des ersten Registers mit einem ersten Eingang einer Addierstufe (108) und des zweiten Registers mit einem ersten Eingang eines Multiplizierers (109) oder umgekehrt enthält, dass der Eingang des ersten Registers (105) mit einem Ausgang einer vorangehenden Zelle verbunden ist, der Eingang des zweiten Registers (104) mit Mitteln zum Multiplexing (112, 113) verbunden ist, deren Eingänge mit dem Ausgang des ersten Registers und des zweiten Registers der vorangehenden Zelle und mit dem Ausgang der Addierstufe (108) verbunden sind, der Ausgang der Zelle durch einen Multiplexer (111) gebildet ist, dessen Eingänge mit dem Ausgang der Addierstufe und mit dem Ausgang der Schaltung (106) verbunden ist, die mit dem ersten Eingang des Multiplizierers verbunden ist, ein zweiter Eingang der Addierstufe (108) mit dem Ausgang des Multiplizierers (110) verbunden ist und ein zweiter Eingang des Multiplizierers (110) zum Empfang eines Multiplikations-Koeffizienten geeignet ist.

5. Koder-Dekoder nach Anspruch 4, **dadurch gekennzeichnet, dass** die zweiten Eingänge des Multiplizierers der Zellen miteinander verbunden sind.

6. Koder-Dekoder nach Anspruch 3 bis 5, **dadurch gekennzeichnet, dass** für die Multiplikation der Löschungs-Polynome (E(z)) und der Syndrom-Polynome (S(z)) der Ausgang des ersten Registers (RTOP(k), 105) einer Zelle mit dem Multiplizierer (110) verbunden ist, der Ausgang des zweiten Registers (RBOT(k), 104) mit der Addierstufe (108) verbunden ist, der Ausgang der Zelle durch den ersten Eingang des Multiplizierers gebildet ist und der Eingang des zweiten Registers (RBOT(k), 104) mit dem Ausgang der Addierstufe (108) verbunden ist.

7. Koder-Dekoder nach Anspruch 6, **dadurch gekennzeichnet, dass** die Koeffizienten eines der beiden zu multilpizierenden Polynome in den ersten Registern der Zellen (RTOP(k), 105) in der Initialisierungsphase gespeichert sind, während die Koeffizienten des anderen Polynoms einer nach dem anderen dem zweiten Eingang des Multiplizierers (110) zugeführt werden.

8. Koder-Dekoder nach Anspruch 2, 4 und 5, **dadurch gekennzeichnet, dass** für die Multiplikation der Polynome der Fehlerortung ($\Lambda$(z)) und der Löschung (E(z)), das erste Register (RTOP(k), 105) einer Zelle mit dem Ausgang der Addierstufe der vorangehenden Zelle (k-1) verbunden ist, der Ausgang des ersten Registers mit dem ersten Eingang der Addierstufe (108) verbunden ist und der Ausgang des zweiten Registers (RBOT(k), 104) mit dem ersten Eingang des Multiplizierers verbunden ist.

9. Koder-Dekoder nach Anspruch 8, **dadurch gekennzeichnet, dass** die Polynom-Koeffizienten für die Ortung ($\Lambda$(z)) in der Initialisierungsphase in den zweiten Registern (RBOT(k)) der Zellen gespeichert sind, wobei die Inhalte dieser zweiten Register während der Multiplikation nicht benutzt werden, dass die Koeffizienten des Löschungspolynoms (E(z)) nacheinander den zweiten Eingängen der Multiplizierer (110) der Zellen zugeführt werden.

10. Leser (200) für optische Platten (201), **dadurch gekennzeichnet, dass** er einen Koder-Dekoder nach einem der vorangehenden Ansprüche enthält.

**Claims**

1. A coder - decoder of the Reed - Solomon type comprising:

   - a syndrome generator (2) to receive a flow of data and for providing a polynomial of syndrome (S(z)) and a polynomial of erasure (E(z));
   - means of implementation (3) of Euclid's algorithm for receiving said polynomial of syndrome (S(z)) and polynomial of erasure (E(z)) and for providing a polynomial of error localization ($\Psi$(z));
   - means of correction (4) for correcting where applicable the error or errors in the data flow with the aid of the polynomial of error localization ($\Psi$(z));

   and in which the means of implementation (3) comprise first and second registers (RTOP, RBOT) for storing two intermediate polynomials of localization and of evaluation of error ($\Lambda$(z), $\Omega$(z)), the registers (RTOP, RBOT) being divided into elementary cells (104, 105) set in series and comprising means of multiplexing (106, 111, 112, 113) and of calculation (108, 110) **characterized in that** the cells are arranged during a cycle of a clock signal where a calculation operation is carried out it is subsequently possible to reverse simultaneously the data between the two registers.

2. A coder - decoder according to claim 1, **characterized in that** the means of implementation (3) are arranged to produce the product of the polynomial of error localization ($\Lambda$(z)) and of the polynomial of erasure (E(z)) for obtaining the polynomial of error localization ($\Psi$(z)).

3. A coder - decoder according to claim 1 or 2, **characterized in that** the means of implementation (3) are arranged to yield the product of the polynomial of syndromes (S(z)) by the polynomial of erasure (E(z)).

4. A coder - decoder according to claims 1 through 3, **characterized in that** the means of implementation (3) comprises r + 1 cells in series, r being the maximum number of redundant symbols, each cell comprising a first register (RTOP(k), 105) for the storage of a polynomial coefficient, a second register (RBOT(k), 104) for the storage of a polynomial coefficient, a circuit (106) for connecting the first register to a first input of an adder (108) and the second register to a first input of a multiplier (109) or inversely, the input of the first register (105) being connected to an output of the preceding cell, the input of the second register (104) being connected to means of multiplexing (112, 113) whose inputs are connected to the output of the first register and of the second register of the preceding cell and to the output of the adder (108), the output of the cell being composed of a multiplexer (111) whose inputs are connected to the output of the adder and to the output of the circuit (106) connected to the first input of the multiplier, a second input of the adder (108) being connected to the output of the multiplier (110), with a second input of the multiplier (110) being suitable for receiving a multiplication coefficient.

5. A coder - decoder according to claim 4, **characterized in that** the second inputs of the multipliers of the cells are connected.

**6.** A coder - decoder according to claims 3 through 5, **characterized in that** for the multiplication of the polynomials of erasure (E(z)) and of syndromes (S(z)) the output of the first register (RTOP(k), 105) of one cell is connected to the multiplier (110), the output of the second register (RBOT(k), 104) is connected to the adder (108), the output of the cell being composed of the first input of the multiplier, and the input of the second register (RBOT(k), 104) being connected to the output of the adder (108).

**7.** A coder - decoder according to claim 6, **characterized in that** the coefficients of one of the two polynomials to be multiplied are stored in the first registers of the cells (RTOP(k), 105) in the initialization phase, while the coefficients of the other polynomial are supplied one by one to the second input of the multiplier (110).

**8.** A coder - decoder according to claims 2, 4, and 5, **characterized in that** for the multiplication of the polynomials of error localization ($\Lambda$(z)) and of erasure (E(z)), the first register (RTOP(k), 105) of a cell is connected to the output of the adder of the preceding cell (k - 1), the output of the first register being connected to the first input of the adder (108), and the output of the second register (RBOT(k), 104) being connected to the first input of the multiplier.

**9.** A coder - decoder according to claim 8, **characterized in that** the coefficients of the polynomial of localization ($\Lambda$(z)) are stored in the second registers (RBOT)(k)) of the cells in the initialization phase, with the contents of these second registers not evolving during the multiplication, the coefficients of the polynomial of erasure (E(z)) being supplied one by one to the second inputs of the multipliers (110) of the cells.

**10.** A reader (200) of optical disks (201) **characterized in that** it comprises a coder - decoder according to any of the preceding claims.

FIG.1

EP 1 076 933 B1

CODE PI

| B 0,0 | | | B 0,171 | B 0,181 |
|---|---|---|---|---|
| | | | | |
| | | | | |
| | | | | |
| | | | | |
| B 191,0 | | | B 191,171 | |
| | | | | |
| | | | | |
| B 207,0 | | | B 207,171 | B 207,181 |

192

16

172 bytes

10 bytes

CODE PO

# FIG.2

FIG.3

FIG.4

EP 1 076 933 B1

FIG.5

SRAM

RAM

E

EP 1 076 933 B1

23

# FIG.6

# FIG.7

4 OCTETS:
124:"SUBCODE ODD FRAME"
125:"S1/S0 REGISTER ODD FRAME"
126:"SUBCODE EVEN FRAME"
127:"S1/S0 REGISTER EVEN FRAME"

FIG.8

FIG.9

FIG.10

EP 1 076 933 B1

FIG.11

EP 1 076 933 B1

FIG.12

EP 1 076 933 B1

PTOP = PBOT = 1

FIG.13

EP 1 076 933 B1

EP 1 076 933 B1

PTOP_IN → D Q PTOP → 103 → PTOP_NEXT

101

PBOT

D Q

102

SWAP

PTOP ≠ PBOT

RTOP_IN → D Q RTOP

105

1

0

SWAP

113

D Q RBOT

104

109 → RTOP_NEXT

106

SWAP

**FIG.14**

FIG.15

EP 1 076 933 B1

0

RTOP (0)    RTOP (1)    RTOP (2)    RTOP (3)

RBOT (0)    RBOT (1)    RBOT (2)    RBOT (3)

SELECT    SELECT    SELECT    SELECT

E

C0    C1    C2    C3

FIG.16

FIG.17